(19) Europäisches Patentamt

European Patent Office

Office européen des brevets

(11) Veröffentlichungsnummer: **0 165 512 B1**

(12) **EUROPÄISCHE PATENTSCHRIFT**

(45) Veröffentlichungstag der Patentschrift: 08.05.91

(21) Anmeldenummer: 85106574.8

(22) Anmeldetag: 29.05.85

(51) Int. Cl.⁵: **H03M 1/00**, G01R 19/00, G01R 19/10, G01R 27/16

(54) Messverfahren zur Ermittlung der Differenz zwischen einer Wechselspannung und einer zweiten Spannung sowie Messvorrichtung zu seiner Anwendung.

(30) Priorität: 13.06.84 DE 3421873

(43) Veröffentlichungstag der Anmeldung:
27.12.85 Patentblatt 85/52

(45) Bekanntmachung des Hinweises auf die
Patenterteilung:
08.05.91 Patentblatt 91/19

(84) Benannte Vertragsstaaten:
AT BE CH DE FR GB IT LI NL SE

(56) Entgegenhaltungen:
EP-A- 0 117 132      DE-A- 2 415 358
DE-A- 2 449 016      DE-B- 1 935 124
GB-A- 1 375 257      JP-A-82 179 667
US-A- 4 204 197

ETZ, Band 14, Nr. 102, 1981, Seiten 762-764,
Berlin, Offenbach; P. DÄNZER:
"Schleifwiderstand und Kurzschlussstrom
gemessen mit Schleifwiderstands-
Messgeräten"

JOURNAL OF PHYSICS E. SCIENTIFIC IN-
STRUMENTS, Band 15, Nr. 8, August 1982,
pages 789-806, Dorking, GB; A.R. OWENS:
"Digital signal conditioning and conversion"

(73) Patentinhaber: **Asea Brown Boveri Aktiengesellschaft
Kallstadter Strasse 1
W-6800 Mannheim-Käfertal(DE)**

(72) Erfinder: **Roppelt, Günter, Dipl.-Ing. (FH)
Rotbuchenstrasse 33
W-8500 Nürnberg(DE)**
Erfinder: **Ziegler, Herbert
Hartensteiner Strasse 66
W-8500 Nürnberg(DE)**
Erfinder: **Schick, Herbert, Dipl.-Ing.(FH)
Albrechtstrasse 7
W-8510 Fürth(DE)**

(74) Vertreter: **Rupprecht, Klaus, Dipl.-Ing. et al
c/o Asea Brown Boveri Aktiengesellschaft
Zentralbereich Patente Postfach 100351
W-6800 Mannheim 1(DE)**

## Beschreibung

In der Meßtechnik kommt es relativ häufig vor, daß die Differenz zwischen zwei Spannungen ermittelt werden muß. Bei Gleichspannungen ist das im allgemeinen einfach, da sich die Differenz unmittelbar durch Subtraktion der einen von der anderen Spannung ergibt. Ist dagegen zumindest eine der beiden Spannungen eine Wechselspannung, so wird diese zunächst gleichgerichtet und durch einen Integrator der Mittelwert gebildet. Die Wechselspannung, wird also in eine Gleichspannung umgewandelt. Um einen brauchbaren Mittelwert zu erhalten, wird gewöhnlich eine Vielzahl von gleichgerichteten Wechselspannungshalbwellen mit einer relativ hohen Zeitkonstante integriert. Die bekannten Schaltungen sind deshalb entsprechend träge.

Aus der etz. (Elektrotechnische Zeitschrift) Band 102 (1981), Heft 14, Seite 762 bis 764 ist ein Meßverfahren zur Messung der Differenz zwischen zwei Wechselspannungen bekannt, wobei eine erste Wechselspannung im Leerlauf und eine zweite Wechselspannung bei Last an einer Wechselspannungsqelle gemessen wird. Bei diesem Verfahren wird mit einem zeitgesteuerten Meßablauf gearbeitet und zwar wird zunächst genau eine Halbwelle der ersten Wechselspannung integriert und somit ein erster Mittelwert U1 gebildet und dann zur Bestimmung eines zweiten Mittelwertes U2 die gleiche Messung bei der zweiten Wechselspannung wiederholt. Durch betragsmäßige Differenzbildung oder vektorielle Addition der Spannung U1 mit der Spannung U2 erhält man die benötigte Differenzspannung $_\triangle$ U.

Das bekannte Verfahren zur Ermittlung der Differenzspannung ist zwar wesentlich schneller als herkömmliche Verfahren, zeigt aber dennoch verschiedene Mängel. So kommt es bei kleinen Differenzspannungen zu relativ großen Fehlern, da der Meßfehler von U1 bzw. U2 für kleine Differenzen von U1-U2 = $_\triangle$ U, größer als die eigentliche Differenz $_\triangle$ U werden kann. Außerdem ist das Verfahren aufwendig, da nach den Integrationen noch eine vektorielle Addition erfolgen muß.

Für eine ganz andere Anwendung, nämlich zur Analog-Digital-Umsetzung ist es bekannt nach dem "Dual-Slope-Verfahren" zu arbeiten, das z.B. im Journal of Physics E. Scientific Instruments, August 1982, Seite 793, Fig. 11 beschrieben ist. Dieses Verfahren ist nur deshalb von Bedeutung, weil hier mit zwei Spannungen ($V_x$, $V_{rel}$) einem zeitgesteuerten Meßablauf, in aufeinanderfolgenden Zeitspannen zuerst die eine und dann die andere Spannung integriert wird. Beide Spannungen werden demselben Integrator (R,C, Operationsverstärker) zugeführt und dieser integriert zuerst die eine der beiden Spannungen auf und anschließend die andere Spannung ab. Wesentlich ist jedoch, daß die zweite Spannung immer eine konstante Referenzspannung sein muß, da nicht die Differenz zweier Spannungen gemessen werden soll, sondern das Verhältnis der Zeiten für die Auf- und Ab-Integration, aus dem wiederum die unbekannte erste Span nung errechnet werden kann.

Aufgabe der Erfindung ist es ein Verfahren der im Oberbegriff des Anspruchs 1 genannten Art und eine zur Anwendung des Verfahrens geeignete Meßvorrichtung zu schaffen, wodurch eine besonders schnelle und mit nur geringen Fehlern behaftete Messung ermöglicht wird.

Diese Aufgabe wird durch die in den Ansprüchen 1 und 9 gekennzeichneten Merkmale gelöst. Vorteilhafte Ausgestaltungen und Weiterbildungen des Erfindungsgegenstandes sind in den Unteransprüchen genannt.

Das erfindungsgemäße Verfahren bringt eine wesentliche Vereinfachung, da nicht mehr zwei Werte getrennt ermittelt werden müssen, um dann ihre Differenz zu bilden, sondern die gesuchte Differenzspannung unmittelbar am Integrator abgenommen werden kann. Vielleicht noch bedeutsamerist, daß sich hierdurch auch der Meßfehler entscheidend verringert. Nimmt man an, daß nach dem erfindungsgemäßen Verfahren der Auf/Abintegration bei der Ermittlung der Differenzspannung ein Fehler von 1 % entsteht, so kann dieser Fehler bei nachträglicher Differenzbildung getrennter Spannungen U1, U2 leicht 40 % und mehr erreichen.

Eine besondere Bedeutung erhält das Verfahren, wenn mindestens eine der beiden Spannungen zwischen denen eine Differenz gemessen werden soll, eine Wechselspannung ist. Im Normalfall wird auch die zweite Spannung eine Wechselspannung sein und eine vorteilhafte Ausgestaltung des Verfahrens sieht dann vor, daß bei der einen Wechselspannung eine gleichgroße Zahl von 1...n Halbwellen gleichgerichtet aufintegriert sowie bei der anderen gleichgerichtet abintegriert wird. Es ist zweckmäßig jeweils beide (positive und negative) Halbwellen einer Periode zu integrieren. Hierdurch werden sowohl bei der Aufintegration, wie auch bei der Abintegration Netzunsymmetrien, z.B. Gleichspannungsanteile, eliminiert.

Eine weitere vorteilhafte Ausgestaltung des Verfahrens sieht vor, daß die Abintegration im gleichen Zeitpunkt (z.B. Nulldurchgang) beginnt, in dem die Aufintegration endet. Durch die unmittelbare Reihenfolge von Auf- und Abintegration über jeweils eine Periode, ist die Gefahr, daß Netzspannungsschwankungen mitgemessen werden, geringer als bei Verfahren, bei denen Pausenzeiten zwischen der Erfassung beider Wechselspannungen auftreten.

Vorteilhaft ist es weiterhin das Verfahren so auszugestalten, daß die Differenzspannung über mehrere, eine Integrationsphase bildende Integrationszyklen ermittelt wird. Jeder Integrationszyklus umfaßt hierbei eine Auf- und eine Abintegration und die am Integrator entstehende Summenspannung wird dann durch die Zahl der Integrationszyklen geteilt, um den Mittelwert der Differenzspannung zu erhalten. Durch diese Maßnahme werden zwei wesentliche Vorteile erzielt. So wird der Einfluß von Netzspannungsschwankungen erheblich reduziert, weil durch das mehrfache Auf- und Abintegrieren eine quasi statistische Mittelwertbildung des Meßwertes erfolgt. Weiterhin führt das Integrieren über mehrere Meßzyklen besonders bei kleinen Differenzspannungen einerseits zu höheren Spannungsabsolutwerten und andererseits durch die Mittelwertbildung zu einer verbesserten Meßgenauigkeit. Durch das unmittelbare Abintegrieren nach jeder Halbwelle bleiben die Ausgangsspannungen am Integrator relativ niedrig, so daß die nachgeschalteten Baugruppen keine große Aussteuerbarkeit besitzen müssen.

Das Verfahren kann auch dahingehend ausgestaltet werden, daß die Länge einer Integrationsphase (die Zahl der Integrationszyklen) so begrenzt ist, daß eine Wiederholung des Integrationszyklus gesperrt wird, sobald der Summenwert am Integrator einen vorgegebenen Grenzwert erreicht. Auf diese Weise kann vermieden werden, daß z.B. bei größeren Differenzspannungen unnötig viel Integrationszyklen für eine Integrationsphase bereitgestellt werden.

Eine weitere Ausbildung des Verfahrens sieht vor, daß sich an jede Integrationsphase eine Meßwertübernahmephase zur Übernahme der am Integrator gebildeten Summenspannung anschließt und vor einer neuen Integrationsphase eine Entladephase kommt, in der der Integrator auf Null gesetzt wird.

Die mit dem Verfahren erzielbare Meßgenauigkeit kann dadurch noch verbessert werden, daß zwischen die Entladephase und die Integrationsphase eine Offsetphase gelegt wird. Während dieser Offsetphase, deren Dauer der Integrationsphase entspricht, wird der Eingang des Integrators kurzgeschlossen und dann die sich am Integrator ergebende Offsetspannung ermittelt. In einer sich an die Offsetphase anschließenden Offsetübernahmephase wird die Offsetspannung mit umgekehrtem Vorzeichen zu der während der Integrationsphase gebildeten Summenspannung addiert.

Das Verfahren sieht in zweckmäßiger Ausgestaltung vor, daß ein Meßzyklus aus einer Nullphase, einer Integrationsphase, einer Meßwertübernahmephase, einer Entladephase und einer Offsetübernahmephase besteht. Am Ende eines Meßzyklus wird der Meßwert unmittelbar oder nach einer A/D-Wandlung und ggf. einer rechnerischen Aufbereitung in einen Speicher übernommen und während einer begrenzten Zeit zur Anzeige gebracht.

Ähnlich wie die Meßgenauigkeit durch mehrere Integrationszyklen und anschließende Mittelwertbildung erhöht werden kann, kann auch das Ergebnis von mehreren Meßzyklen zur Anzeige gebracht werden. Hierbei wird nach jedem Meßzyklus der Meßwert zwischengespeichert, mit den Meßwerten weiterer Meßzyklen addiert und daraus der Mittelwert gebildet.

Eine der wichtigsten Anwendungen findet das erfindungsgemäße Meßverfahren im Rahmen der Spannungsabsenkung. Hierbei werden die unterschiedlichen Wechselspannungen durch unterschiedliche Belastung der Wechselspannungsquelle erzeugt. Der Belastungswechsel wird dabei so gesteuert, daß er zeitsynchron mit dem Meßablauf ist. Durch Verbindung des bekannten Spannungsabsenkungsverfahrens mit dem erfindungsgemäßen Prinzip der Auf/Abintegration gelingt es auf sehr einfache Weise in Wechselspannungsnetzen die Berührungsspannung oder den Netzinnenwiderstand zu messen.

Das Verfahren läßt sich dadurch noch verbessern, daß der erste Lastzustand vorzugsweise einem unbelasteten Zustand entspricht und der zweite Lastzustand durch einen konstanten (eingeprägten) Laststrom mit einer der Wechselspannung entsprechenden gleichen Wellenform erzeugt wird. Durch die Belastung der Netzspannungsquelle mit Konstantstrom, anstelle mit einem sonst üblichen ohmschen Widerstand entfällt ein separates Messen des Laststromes. Die gemessene Differenzspannung hangt selbstverständlich vom Laststrom ab, der, wenn er nicht eingeprägt ist, sich mit dem jeweiligen Schleifenwiderstand und der Spannung des Netzes ändert. Vorteilhaft ist weiterhin, daß der beim Einschalten der Last auftretende Einschwingvorgang weitgehend entfällt, da der Strom sinusförmig aufgezwungen wird.

In Verbindung mit dem erfindungsgemäßen Meßverfahren und der damit bewirkten erhöhten Meßgenauigkeit kann der eingeprägte Laststrom gegenüber bekannten Verfahren um den Faktor 10 bis 100 reduziert werden. Verwendet man das Verfahren im Rahmen der Überprüfung von Schutzmaßnahmen in elektrischen Anlagen, so kann mit dem kleineren Laststrom wesentlich gefahrloser gemessen werden, weil die hierbei auftretenden Berührungsspannungen niedriger sind. Auch können hierdurch noch relativ schwach abgesicherte Stromkreise (gleich oder kleiner 1,5 Ampere) geprüft werden.

Im Rahmen der Überprüfung von Schutzmaßnahmen in elektrischen Anlagen können durch das erfindungsgemäße Meßverfahren noch weitere Größen ermittelt werden. So ist es möglich aus der Differenzspannung und dem konstanten Laststrom den Innenwiderstand der Wechselspannungsquelle direkt auszuwerten und aus der im unbelasteten Zustand gemessenen Leerlaufspannung der Wechselspannungsquelle und ihrem Innenwiderstand den Kurzschlußstrom zu bestimmen.

Eine Meßvorrichtung zur Anwendung des Meßverfahrens ist mit zwei an einer Wechselspannung liegenden Spannungsteilern ausgestattet und im weiteren so aufgebaut, daß eine Automatik zum Steuern und Rechnen vorzugsweise durch einen Mikroprozessor realisiert ist, der über einen am ersten Spannungsteiler liegenden Komparator und einen zwischengeschalteten Logikbaustein die Nulldurchgänge der Wechselspannung erfaßt. In Abhängigkeit von den Nulldurchgängen steuert die Automatik nach einem vorgegebenen Programm mehrere Schalter, von denen ein erster Schalter und ein dazu parallel liegender zweiter Schalter den zweiten Spannungsteiler mit dem Eingang eines Integrators verbinden. Dabei ist einem dieser beiden Schalter in Inverter vorgeschaltet, und außerdem ist der Ausgang des Integrators durch einen dritten Schalter überbrückt.

Zur Auswertung der am Ausgang des Integrators anliegenden Spannungen ist dieser mit dem Eingang eines A/D-Wandlers verbunden, der seinerseits über die Automatik (den Mikroprozessor) mit einer Digitalanzeige in Verbindung steht. Nach der zunächst analog durchgeführten Integration erfolgt die weitere Meßwertverarbeitung digital.

Außer dem ersten und dem zweiten Schalter, die im Rahmen der Integration zur Anwendung kommen und dem dritten Schalter, der für den Integrator die Entladephase einleitet, ist noch ein vierter Schalter vorgesehen. Dieser liegt zwischen dem zweiten Spannungsteiler und der Parallelschaltung des ersten und zweiten Schalters und ermöglicht ein Kurzschließen des Integratoreingangs und damit die Durchführung der Offsetphase.

Schließlich ist noch ein fünfter Schalter mit einem hierzu in Reihe liegenden Lastwiderstand vorgesehen, der die beiden Spannungsteiler überbrückt und somit vom Mikroprozessor zeitsynchron zum Meßablauf gesteuert das Messen einer Leerlaufspannung und einer Wechselspannung unter Last erlaubt.

Eine ganz andersartige Anwendung des erfindungsgemäßen Meßverfahrens ergibt sich dann, wenn beide Spannungen Gleichspannungen sind, oder eine der beiden Spannungen eine Wechselspannung und die andere eine Gleichspannung ist und die Gleichspannung einen vorgegebenen einstellbaren Wert besitzt. Die Gleichspannung kann hierbei als Bezugswert zur Unterdrückung eines nicht interessierenden Teiles der zu messenden anderen Spannung genutzt werden. Die verbleibende Differenzspannung, auf die es bei der Messung ankommt, ermöglicht bei entsprechender Spreizung der für die Anzeige dienenden Analogskala eine erhöhte Ablesegenauigkeit. Durch Verändern des Bezugswertes kann der gedehnte Bereich der Differenzspannung U über einen beliebigen Meßbereich verschoben werden.

Eine Messung der Differenz von zwei Gleichspannungen mit Hilfe der Auf/Ab-Integration ist besonders dann einer direkten Differenzspannungsmessung vorzuziehen, wenn die beiden Spannungen aus verschiedenen Spannungsquellen stammen, die auf unterschiedlichem Potential liegen und somit nicht zusammengeschaltet werden können.

Ein Ausführungsbeispiel der Erfindung ist in den Zeichnungen dargestellt und wird im folgenden näher beschrieben.

Es zeigen:

Figur 1: Ein Prinzipschaltbild der erfindugsgemäßen Meßvorrichtung,

Figur 2: den Meßablauf und die Signale bei einer Messung des Netzinnenwiderstandes.

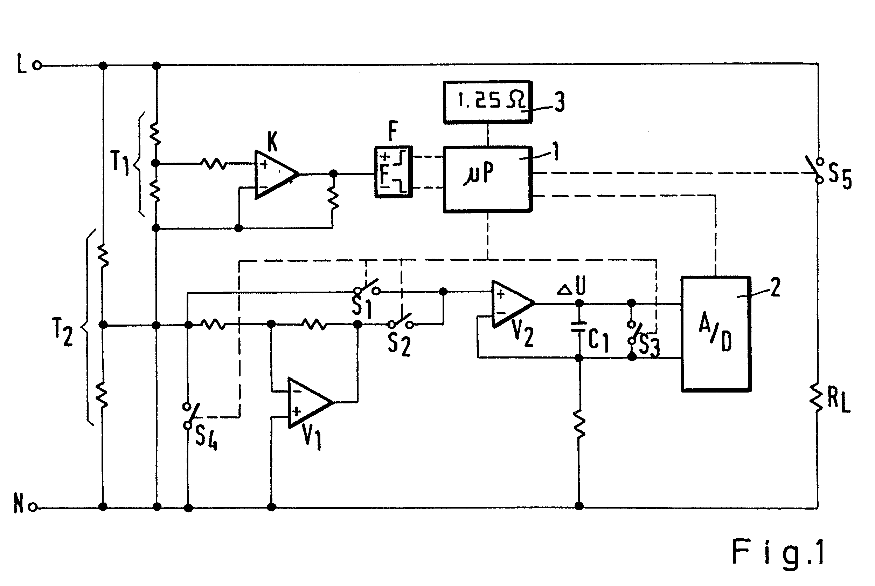

Wie Figur 1 zeigt, liegen an einer Netzspannung zwischen Phase L und Null-Leiter N zwei Spannungsteiler T1 und T2. Die Netzspannung könnte selbstverständlich auch zwischen Phase und dem Schutzleiter oder zwei Phasen gemessen werden. Von der am Spannungsteiler T1 anliegenden Wechselspannung werden durch einen Komparator K und einen Logikbaustein F nur die Nulldurchgänge erfaßt und sowohl der positive wie auch der negative Nulldurchgang einem Mikroprozessor 1 als Zeitsignal zugeführt. In Abhängigkeit von den Nulldurchgängen steuert nunmehr der Mikroprozessor 1 eine Vielzahl von Funktionselementen. So wird die von dem zweiten Spannungsteiler T2 abgegriffene Wechselspannung über zwei Schalter S1 und S2 dem Eingang eines Integrators V2 zugeführt. Vor den Schalter S2 ist ein Inverter V1 eingefügt, der dafür sorgt, daß die Wechselspannung gegenphasig, also um 180 $^{\circ}$C gedreht, an den beiden Schaltern S1, S2 anliegt. Beide Schalter werden so getaktet, daß dem Integrator V2, C1 abwechselnd zwei positive und dann zwei negative Halbwellen zugeführt werden. Es wird somit über je zwei Halbwellen aufintegriert und anschließend über je zwei Halbwellen abintegriert. Die am Ausgang des Integrators V2, C1 verbleibende Spannung $_\triangle$U ist dem Mittelwert der Differenzspannung proportional. Die Ausgangsspannung des Integrators V2C1 wird einem Analogdigitalwandler zugeführt, der eine weitere Verarbeitung des Meßwertes erlaubt. Die Weiterverarbeitung erfolgt mit Hilfe des Mikroprozessors 1, der den gewonnenen Meß- oder Rechenwert auf einem Display 3 digital darstellt.

Ein den Ausgang des Integrators V2C1 überbrückender dritter Schalter S3 dient dazu nach jeder Integrationsphase und einer sich daran anschließenden Meßwertübernahmephase den Kondensator C1 zu entladen. An die Entladephase kann sich noch eine Offsetphase anschließen, während der mit Hilfe eines vierten Schalters S4 der Eingang des Integrators V2C1 noch vor dem Inverter V1 kurzgeschlossen werden kann. Dadurch gelangt wahrend der Offsetphase keine von der Wechselspannung abgeleitete Meßspannung, sondern nur eine schaltungsinterne Fehlerspannung zur Integration. Uber einen fünften Schalter S5 kann die Netzspannungsquelle LN mit einem Widerstand RL belastet werden. Der über den fünften Schalter S5 steuerbare Wechsel zwischen Last und Leerlauf führt zu zwei unterschiedlichen Spannungen an dem Spannungsteiler T2. Die sich hieraus ergebende Differenzspannung wird von der Meßvorrichtung ermittelt und auf dem Display 3 als Spannungs- oder Widerstandswert bzw. Kurzschlußstrom direkt dargestellt.

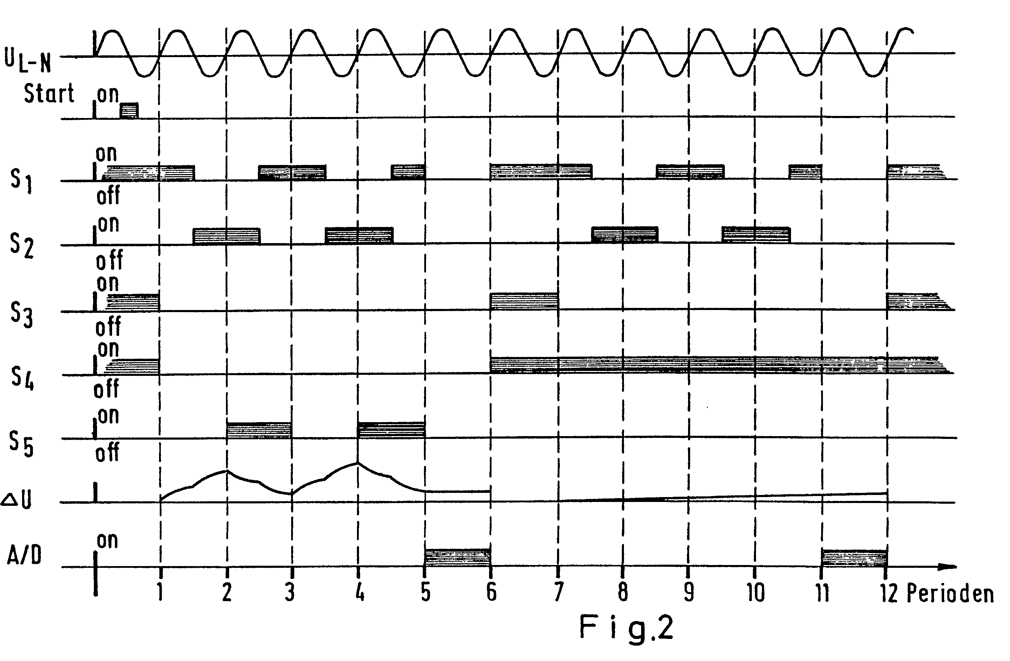

In Figur 2 ist der Signalablauf dargestellt, der sich beim Messen eines Netzinnenwiderstandes ergibt. Hierbei ist eine Integrationsphase auf zwei Meßzyklen mit je einer Auf- und Abintegration beschränkt. Es sind die Signale der Netzwechselspannung, das Startsignal, die Schaltsignale aller Schalter S1 bis S5, das Signal der am Integratorausgang gemessenen Differenzspannung $\triangle U$ bzw. ihres Mittelwertes und das Steuersignal für den Analog/Digital-Wandler zur Ubernahme des vom Integratorausgang abgenommenen Signals. Die Darstellung geht über zwölf Perioden des Wechselspannungssignals und erfaßt in der ersten Periode die Nullphase, in der das Startsignal liegt, von der zweiten bis zur fünften Periode eine Integrationsphase mit zwei je eine Auf- und eine Abintegration umschließende Integrationszyklen, in der sechsten Periode eine Meßwertübernahmephase, in der siebten Periode eine Entladephase, in der achten bis elften Periode eine Offsetphase, und in der zwölften Periode eine Offsetübernahmephase.

Nach der Nullphase beginnt die Aufintegration. Der Logikbaustein F signalisiert dem Mikroprozessor den positiven bzw. negativen Spannungsnulldurchgang. Der Mikroprozessor startet die Aufintegration mit dem positiven Nulldurchgang, wobei der dritte Schalter S3 geöffnet ist. Die über den Teiler T2 angepaßte Meßspannung wird für die positive Halbwelle über den ersten Schalter S1 und für die negative Halbwelle über den Inverter V1 und den zweiten Schalter S2 dem Integrator V2C1 zugeführt. Am Integrationskondensator C1 stellt sich ein den angelegten Halbwellen proportionaler Mittelwert der gemessenen Spannung ein.

Die Abintegration erfolgt unmittelbar nach der Aufintegration. Der Start wird wie bei dieser über den Komparator K und den Logikbaustein F vom Nulldurchgang abgeleitet. Gleichzeitig mit dem Einschalten des Lastwiderstandes RL über den fünften Schalter S5 wird der zweite Schalter S2 für die positive Halbwelle und der erste Schalter S1 für die negative Halbwelle geschlossen. D.h. die eine Gleichrichtung bewirkenden Schalter S1 und S2 werden gegenüber der Aufintegration invertiert gesteuert.

Am Integrationskondensator C1 bildet sich die Differenzspannung $\triangle U$, die bei gleicher Intervallzeit für die Auf- und Abintegration dem Netzinnenwiderstand proportional ist.

Die Meßspannung $\triangle U$ wird am Integrationskondensator C1 abgegriffen und steht gleichzeitig an dem Analog/Digital-Wandler 2 zur Verfügung. Am Ende eines Integrationszyklus ruft der Mikroprozessor den Augenblickwert des Analog/Digital-Wandlers ab.

Ein Integrationszyklus kann aus einem oder mehreren Auf- und Abintegrationen bestehen. Wird das Verfahren zur Uberprüfung von Schutzmaßnahmen in elektrischen Anlagen eingesetzt, so ist es zweckmäßig die Integrationsphase auf 0,2 Sekunden zu begrenzen, um eine Berührungsspannungsgefährdung bei unzulässig hohen Erdungs- bzw. Schleifenwiderständen zu vermeiden Andererseits kann zur Meßbereichserweiterung sowie zur Reduzierung von Meßfehlern, bei insbesondere niederohmigen Spannungsquellen, ein Meßvorgang auf mehrere Integrationszyklen erweitert werden. Der erste Integrationszyklus mit 0,2 Sekunden Dauer beinhaltet gleichzeitig eine Vorprüfung zur Ermittlung der Größenordnung des Meßwertes bzw. der Berührungsspannung. Ist der Meßbereich hierbei schon genügend ausgesteuert oder die Berührungsspannung zu hoch, so werden weitere Integrationszyklen gesperrt.

Hat der Mikroprozessor den Meßwert als gültig akzeptiert, so erfolgt gleich zu Beginn der an die Abintegration sich anschließenden Spannungsperiode die Meßwertübernahme. In einer weiteren Periode wird dann der Integrationskondensator über den dritten Schalter S3 entladen.

Bei der sich nun anschließenden Offsetphase wird der Eingang des Integrators V2C1 noch vor den beiden Schaltern S1, S2 durch einen vierten Schalter S4 kurzgeschlossen. Im gleichen Takt wie während der Integrationsphase von der zweiten bis zur fünften Periode werden nun die beiden Schalter S1 und S2 während der achten bis elften Periode geschaltet. Die so am Integrationskondensator C1 entstandene Offsetspannung wird ebenfalls über den Analog/Digital-Wandler in der zwölften Periode vom Mikroprozessor abgerufen und der Meßwert entsprechend korrigiert. Da der Meßpfad dem Offsetpfad genau entspricht und auch das Zeitintervall völlig gleich gewählt wird, wird die Offsetspannung optimal ausgeregelt.

Der Mikroprozessor steuert mit dem so korrigierten Meßwert die Anzeige an. Der zuletzt erzielte Meßwert wird für ca. 15 Sekunden weiter angezeigt. Nach Ablauf dieser Zeit aber auch bereits vorher kann eine neue Meßphase durch einen Startimpuls eingeleitet werden.

**Ansprüche**

1. Meßverfahren zur Ermittlung der Differenz zwischen zwei Spannungen durch einen zeitgesteuerten Meßablauf, der dafür sorgt, daß in aufeinanderfolgenden, fest vorgegebenen Zeitspannen zuerst die eine und dann die andere Spannung integriert wird, dadurch gekennzeichnet, daß die beiden Spannungen mit entgegengesetzter Polarität demselben Integrator zugeführt werden und dieser zuerst die eine der beiden Spannungen aufintegriert und anschließend die andere Spannung, vorzugsweise über die gleiche Zeitspanne, abintegriert und nach Abschluß eines solchen Integrationszyklus am Ausgang eine Spannung abgibt, die dem Mittelwert der Differenz beider Spannungen entspricht.

2. Meßverfahren nach Anspruch 1, dadurch gekennzeichnet, daß beide Spannungen Wechselspannungen sind und bei der einen eine gleich große Zahl von mehreren Halbwellen gleichgerichtet aufintegriert wird wie bei der anderen gleichgerichtet abintegriert wird und vorzugsweise jeweils beide Halbwellen einer Periode integiert werden.

3. Meßverfahren nach Anspruch 1 oder 2, dadurch gekennzeichnet, daß die Abintegration im gleichen Nulldurchgang beginnt, in dem die Aufintegration endet und die Differenzspannung über mehrere, eine Integrationsphase bildende Integrationszyklen ermittelt wird, wobei jeder Integrationszyklus eine Auf- und eine Abintegration umfaßt und die am Integrator entstehende Summenspannung durch die Zahl der Integrationszyklen geteilt wird.

4. Meßverfahren nach einem der vorhergehenden Ansprüche, dadurch gekennzeichnet, daß die Länge einer Integrationsphase so begrenzt ist, daß eine Wiederholung des Integrationszyklus gesperrt wird, sobald der Summenwert am Integrator einen vorgegebenen Grenzwert erreicht und daß sich an jede Integrationsphase eine Meßwertübernahmephase zur Übernahme der am Integrator gebildeten Summenspannung anschließt und vor einer neuen Integrationsphase eine Entladephase kommt, in der der Integrator auf Null gesetzt wird.

5. Meßverfahren nach Anspruch 4, dadurch gekennzeichnet, daß sich auf die Entladephase eine Offsetphase anschließt, während der der Eingang des Integrators kurzgeschlossen wird und deren Dauer gleich der Integrationsphase ist und daß in einer sich an die Offsetphase anschließenden Offsetübernahmephase die Offsetspannung von der Summenspannung subtrahiert wird.

6. Meßverfahren nach einem der vorhergehenden Ansprüche, dadurch gekennzeichnet, daß ein Meßzyklus aus einer Nullphase, einer Integrationsphase, einer Meßwertübernahmephase, einer Entladephase, einer Offsetphase und einer Offsetübernahmephase besteht und am Ende eines Meßzyklus ein Meßwert als Ergebnis einer Analog/Digital-Wandlung und ggf. einer rechnerischen Aufbereitung in einen Speicher übernommen wird und während einer begrenzten Zeit zur Anzeige gelangt und daß das Ergebnis von mehreren Meßzyklen zur Anzeige gebracht wird, wobei nach jedem Meßzyklus der Meßwert zwischengespeichert, mit den Meßwerten weiterer Meßzyklen addiert und daraus der Mittelwert gebildet wird.

7. Meßverfahren nach einem der vorhergehenden Ansprüche, dadurch gekennzeichnet, daß die unterschiedlichen Wechselspannungen nach dem Prinzip der Spannungsabsenkung durch unterschiedliche Belastung der Wechselspannungsquelle erzeugt werden und der Belastungswechsel zeitsynchron durch den Meßablauf gesteuert wird und daß der erste Lastzustand vorzugsweise einem unbelasteten Zustand entspricht und der zweite Lastzustand durch einen konstanten Laststrom mit einer der Wechselspannung entsprechenden gleichen Wellenform erzeugt wird.

8. Meßverfahren nach Anspruch 7, dadurch gekennzeichnet, daß aus der ermittelten Differenzspannung und dem konstanten Laststrom der Innenwiderstand der Wechselspannungsquelle direkt ausgewertet wird und aus der im unbelasteten Zustand gemessenen Leerlaufspannung der Wechselspannungsquelle und ihrem Innenwiderstand der Kurzschlußstrom bestimmt wird.

9. Meßverfahren nach Anspruch 1, dadurch gekennzeichnet, daß beide Spannungen Gleichspannungen sind oder daß eine der beiden Spannungen eine Wechselspannung und die andere eine Gleichspannung ist und daß die Zeitsteuerung des Meßablaufs durch einen geräteinternen Meßtakt vorgegeben ist.

10. Meßverfahren nach Anspruch 1 dadurch gekennzeichnet, daß eine der beiden Spannungen, vorzugsweise eine Gleichspannung, als Bezugswert zur Unterdrückung eines Teiles einer zu messenden anderen Spannung dient, wobei der Bezugswert einstellbar ist, so daß der durch die Unterdrückung gedehnte Bereich der Differenzspannung $\Delta U$ über den Meßbereich verschoben werden kann.

11. Meßvorrichtung mit zwei an einer Wechselspannung liegenden Spannungsteilern (T1,T2) zur Anwendung des Meßverfahrens nach einem der Ansprüche 1 bis 10, dadurch gekennzeichnet, daß eine Automatik (1) zum Steuern und Rechnen, vorzugsweise ein Mikroprozessor, über einen am ersten Spannungsteiler (T1) liegenden Komparator (K) und einen zwischengeschalteten Logikbaustein (F) die Nulldurchgänge der Wechselspannung erfaßt und in Abhangigkeit von diesen nach einem vorgegebenen Programm mehrere Schalter (S1 bis S3) steuert, wobei ein erster Schalter (S1) und ein dazu parallel liegender zweiter Schalter (S2) den zweiten Spannungsteiler (T2) mit dem Eingang eines Integrators (V2C1) verbinden und einem dieser beiden Schalter (S1,S2) ein Inverter (V1) vorgeschaltet ist und der Ausgang des Integrators (V2C1) durch einen dritten Schalter (S3) überbrückt ist.

12. Meßvorrichtung nach Anspruch 11, dadurch gekennzeichnet, daß der Ausgang des Integrators mit dem Eingang eines Analog/Digital-Wandlers (2) verbunden ist, der seinerseits über die Automatik (1) mit einer Digitalanzeige (3) in Verbindung steht und daß zwischen dem zweiten Spannungsteiler (T2) und der Parallelschaltung des ersten und zweiten Schalters (S1,S2) eine vierter Schalter (S4) liegt, der den Eingang des Integrators (V2,C1) überbrückt und daß die Spannungsquelle an der die beiden Spannungsteiler (T1,T2) liegen, durch einen fünften Schalter (S5) und einen hierzu in Reihe liegenden Lastwiderstand (RL) belastbar ist.

## Claims

1. Method of measurement for determining the difference between two voltages by means of a time-controlled measurement sequence which ensures that in sequential, definitively prescribed time intervals firstly one and then the other voltage is integrated, characterised in that the two voltages are fed with opposite polarity to the same integrator and the latter firstly integrates one of the two voltages upslope and subsequently integrates the other voltage, preferably over the same time interval, downslope, and after termination of such an integration cycle transmits at the output a voltage which corresponds to the mean value of the difference of the two voltages.

2. Method of measurement according to Claim 1, characterised in that the two voltages are alternating voltages, and in the case of the one an identically large number of a plurality of half waves is integrated, rectified, upslope as is integrated, rectified, downslope in the case of the other, and preferably both half waves of a period are integrated in each case.

3. Method of measurement according to Claim 1 or 2, characterised in that the downslope integration starts at the same zero crossing at which the upslope integration ends, and the differential voltage is determined over a plurality of integration cycles forming an integration phase, each integration cycle comprising an upslope and a downslope integration, and the sum voltage arising at the integrator being divided by the number of the integration cycles.

4. Method of measurement according to one of the preceding claims, characterised in that the length of an integration phase is limited such that a repetition of the integration cycle is blocked as soon as the sum value at the integrator reaches a prescribed limiting value, and in that each integration phase is followed by a measured value transfer phase for transfer of the sum voltage formed at the integrator, and a discharge phase in which the integrator is set to zero comes before each new integration phase.

5. Method of measurement according to Claim 4, characterised in that the discharge phase is followed by an offset phase during which the input of the integrator is short-circuited, and whose duration is equal to the integration phase, and in that in an offset transfer phase following the offset phase the offset voltage is subtracted from the sum voltage.

6. Method of measurement according to one of the preceding claims, characterised in that a measurement cycle consists of a zero phase, an integration phase, a measured value transfer phase, a discharge phase, an offset phase and an offset transfer phase, and at the end of a measurement cycle a measured value is transferred into a memory as a result of analog/digital conversion and, possibly, arithmetic processing, and comes to be displayed during a limited time, and in that the result of the plurality of measurement cycles is displayed, after each measurement cycle the measured value being intermediately stored, added to the measured values of further measurement cycles, and the mean value being formed therefrom.

7. Method of measurement according to one of the preceding claims, characterised in that the different alternating voltages are generated according to the principle of voltage reduction by different loading of the alternating-voltage source, and the load variation is controlled by the measurement sequence in a time-synchronous fashion, and in that the first load state preferably corresponds to an unloaded state and the second load state is generated by a constant load current having an identical waveform corresponding to the alternating voltage.

8. Method of measurement according to Claim 7, characterised in that the internal impedance of the alternating-voltage source is evaluated directly from the determined differential voltage and the constant load current, and the short-circuit current is determined from the open-circuit voltage, measured in the unloaded state, of the alternating-voltage source and its internal impedance.

9. Method of measurement according to Claim 1, characterised in that both voltages are direct voltages, or one of the two voltages is an alternating voltage and the other a direct voltage, and in that the time control of the measurement sequence is prescribed by a measurement clock pulse internal to the equipment.

10. Method of measurement according to Claim 1, characterised in that one of the two voltages, preferably a direct voltage, serves as reference value for the purpose of suppressing a proportion of another voltage that is to be measured, the reference value being adjustable, so that the range, expanded by the suppression, of the differential voltage $\triangle U$ can be shifted over the range of measurement.

11. Measuring device having two voltage dividers (T1, T2) connected to an alternating voltage for application of the method of measurement according to one of Claims 1 to 10, characterised in that an automatic system (1) for controlling and computing preferably a microprocessor, detects the zero crossings of alternating voltage via a comparator (K), connected to the first voltage divider (T1), and an interposed logic unit (F), and depending upon said zero crossings controls a plurality of switches (S1 to S3) according to a prescribed program, a first switch (S1) and a second switch (S2), connected in parallel thereto, connecting the second voltage divider (T2) to the input of an integrator (V2C1) and an inverter (V1) is connected upstream of one of said two switches (S1, S2), and the output of the integrator (V2C1) is short-circuited by a third switch (S3).

12. Measuring device according to Claim 11, characterised in that the output of the integrator is connected to the input of an analog/digital converter (2), which for its part is connected to a digital display (3) via the automatic system (1) and in that connected between the second voltage divider (T2) and the parallel circuit of the first and second switch (S1, S2) is a fourth switch (S4), which short-circuits the input of the integrator (V2, C1) and in that the voltage source, to which the two voltage dividers (T1, T2) are connected, can be loaded by means of a fifth switch (S5) and a load impedance (RL) connected in series hereto.

**Revendications**

1. Procédé de mesure pour déterminer la différence entre deux tensions par un processus de mesure commandé dans le temps, dans lequel, dans des laps de temps successifs, fixes et prédéterminés, on intègre la première tension puis l'autre tension, caractérisé par le fait que les deux tensions sont appliquées, avec des polarités opposées, au même intégrateur qui intègre d'abord par cumul positif la première des deux tensions puis intègre par cumul négatif l'autre tension, de préférence sur un laps de temps identique, et après la fin d'un tel cycle d'intégration fournit à sa sortie une tension correspondant à la valeur moyenne de la différence des deux tensions.

2. Procédé de mesure selon revendication 1, caractérisé par le fait que les deux tensions sont des tensions alternatives dont la première est redressée et intégrée par cumul positif, cela pour un nombre d'alternances égal à celui pour lequel l'autre tension est redressée et intégrée par cumul négatif, l'intégration étant faite de préférence à chaque fois pour deux alternances d'une période.

3. Procédé de mesure selon revendication 1 ou 2, caractérisé par le fait que l'intégration par cumul négatif commence au passage par zéro pour lequel l'intégration par cumul positif se termine, et la tension de différence est déterminée sur plusieurs cycles d'intégration formant une phase d'intégration, chaque cycle d'intégration comportant une intégration par cumul positif et une intégration par cumul négatif, et la tension-somme s'établissant à l'intégrateur est divisée par le nombre des cycles d'intégration.

4. Procédé de mesure selon l'une des revendications précédentes, caractérisé par le fait que la longueur d'une phase d'intégration est limitée de manière qu'une répétition du cycle d'intégration soit interdite dès que la valeur-somme à l'intégrateur atteint une valeur-limite prédéterminée, et par le fait qu'à chaque phase d'intégration succède une phase de prise en charge de la valeur de mesure afin de prendre en charge la tension-somme formée à l'intégrateur, et qu'une phase de décharge, dans laquelle l'intégrateur est mis à zéro, survient avant une nouvelle phase d'intégration.

5. Procédé de mesure selon revendication 4, caractérisé par le fait qu'à la phase de décharge succède une phase de décalage pendant laquelle l'entrée de l'intégrateur est mise en court-circuit et dont la durée est égale à la phase d'intégration, et par le fait que la tension de décalage est soustraite de la tension-somme au cours d'une phase de prise en charge du décalage, laquelle succède à la phase de décalage.

6. Procédé de mesure selon l'une des revendications précédentes, caractérisé par le fait qu'un cycle de mesure est constitué par une phase de zéro, une phase d'intégration, une phase de prise en charge de valeur de mesure, une phase de décharge, une phase de décalage et une phase de prise en charge de décalage, et, à la fin d'un cycle de mesure, une valeur de mesure est prise en charge, en tant que résultat d'une conversion analogique/numérique et éventuellement d'un traitement par calcul, dans une mémoire et est affichée pendant un temps déterminé, et par le fait que le résultat de plusieurs cycles de mesure est affiché, la valeur de mesure étant mémorisée après chaque cycle de mesure, ajoutée aux valeurs de mesure d'autres cycles de mesure, ce à partir de quoi la valeur moyenne est formée.

7. Procédé de mesure selon l'une des revendications précédentes, caractérisé par le fait que les différentes tensions alternatives sont produites selon le principe de la chute de tension par charge différente de la source de tension alternative, et la variation de charge est commandée en synchronisme par le processus de mesure, et par le fait que le premier état de charge correspond de préférence à un état non chargé et le deuxième état de charge est produit par un courant de charge constant ayant une forme d'onde identique à celle de la tension alternative.

8. Procédé de mesure selon revendication 7, caractérisé par le fait qu'à partir de la tension-différence déterminée et du courant de charge constant, on évalue directement la résistance interne de la source de tension alternative et, à partir de la tension à vide mesurée à l'état non chargé de la source de tension alternative et de sa résistance interne on détermine le courant de court-circuit.

9. Procédé de mesure selon revendication 1, caractérisé par le fait que les deux tensions sont des tensions continues, ou que l'une des deux tensions est alternative et l'autre est continue, et par le fait que la chronologie de commande du processus de mesure est donnée par un rythme de mesure interne de l'appareil.

10. Procédé de mesure selon revendication 1, caractérisé par le fait que l'une des deux tensions, de préférence une tension continue, sert de valeur de référence pour la suppression d'une partie d'une autre tension à mesurer, la valeur de référence étant réglable de manière que le domaine de la tension-différence $_{\triangle}U$, étendu du fait de la suppression, puisse être déplacé sur le domaine de mesure.

11. Dispositif de mesure comportant deux diviseurs de tension (T1, T2) reliés à une tension alternative, pour mettre en oeuvre le procédé de mesure selon l'une des revendications 1 à 10, caractérisé par le fait qu'un moyen automatique (1) pour commander et calculer, de préférence un microprocesseur, décèle, par l'intermédiaire d'un comparateur (K) relié au premier diviseur de tension. (T1) et d'un module logique intercalaire (F), les passages par zéro de la tension alternative et commande en fonction de ceux-ci plusieurs interrupteurs (S1 à S3), selon un programme prédéterminé, un premier interrupteur (S1) et un deuxième interrupteur (S2) monté en parallèle de celui-ci reliant le deuxième diviseur de tension (T2) à l'entrée d'un intégrateur (V2 C1), et l'un de ces deux interrupteurs (S1, S2) étant précédé d'un inverseur (V1), la sortie de l'intégrateur (V2, C1) étant shuntée par un troisième interrupteur (S3).

12. Dispositif de mesure selon revendication 11, caractérisé par le fait que la sortie de l'intégrateur est reliée à l'entrée d'un convertisseur analogique/numérique (2), lequel est lui-même en communication, via le moyen automatique (1), avec un afficheur numérique (3), et par le fait qu'entre le deuxième diviseur de tension (T2) et le circuit parallèle du premier et du deuxième interrupteur (S1, S2) est disposé un quatrième interrupteur (S4) qui shunte l'entrée de l'intégrateur (V2, C1), et par le fait que la source de tension à laquelle les deux diviseurs de tension (T1, T2) sont reliés peut être chargée par un cinquième interrupteur (S5) branché en série avec une résistance de charge (RL).

Fig.1

Fig.2

EP 0 165 512 B1